# EUROPEAN PATENT APPLICATION

(11) **EP 4 848 922 A1**
(43) Date of publication of application: **02.12.2026**
(21) Application number: 25824334.4
(22) Date of filing: 02.01.2025
(51) Int. Cl.: H10B 12/00

(54) **SEMICONDUCTOR STRUCTURE, AND METHOD FOR MANUFACTURING SEMICONDUCTOR STRUCTURE**

(30) Priority: 28.06.2024 CN 202410868782
(71) Applicant: CXMT Corporation, Hefei City, Anhui Province 230601 (CN)
(72) Inventor: GUO, Qi, Hefei, Anhui 230601 (CN); YANG, Xiaodong, Hefei, Anhui 230601 (CN); HE, Moufei, Hefei, Anhui 230601 (CN); ZHANG, Chenyang, Hefei, Anhui 230601 (CN); LI, Lei, Hefei, Anhui 230601 (CN)
(74) Representative: Gulde & Partner
(86) International application number: PCT/CN2025/070151
(87) International publication number: WO 2026/000939

(57) **Abstract**

Provided are a semiconductor structure and a manufacturing method for a semiconductor structure. The semiconductor structure includes: a substrate; a stacked structure located on the substrate, where the stacked structure includes multiple stacked units stacked in a direction perpendicular to a surface of the substrate, and each of the stacked units includes at least a stack of one memory cell member and one isolation structure; and a stress adjustment layer located between the stacked structure and the substrate. The stress adjustment layer includes a first silicon germanium layer. The first silicon germanium layer is made of a material including germanium-doped silicon, with a germanium content being a first component ratio, and the first component ratio is linearly correlated with a ratio of a thickness of the memory cell member or a thickness of the isolation structure to a thickness of the stacked unit. A direction of thickness is a direction perpendicular to the surface of the substrate. According to the above-mentioned semiconductor structure, a semiconductor device with a warpage problem alleviated can be obtained.

## Description

This application is based on and claims priority of the Chinese Patent Application No. 202410868782.4, filed with China National Intellectual Property Administration on June 28, 2024 and entitled "SEMICONDUCTOR STRUCTURE AND MANUFACTURING METHOD THEREFOR". The above-referenced application is incorporated herein by reference in its entirety.

### TECHNICAL FIELD

Embodiments of the present disclosure relate to the field of semiconductor technologies, and in particular, to a semiconductor structure and a manufacturing method therefor.

### BACKGROUND

In the development of dynamic random access memories (DRAMs), performance indicators such as high speed, high integration density, and low power consumption are pursued. With the dimensional miniaturization of semiconductor device structures, existing structures encounter increasingly apparent technological barriers. Therefore, developing more novel structures based on existing structures is a favorable means to break down existing technological barriers.

A three-dimensional dynamic random access memory (3D DRAM), especially a 3D DRAM including a multilayer horizontal cell (MHC), generally includes multiple transistors stacked on a substrate, which meets the above-mentioned requirements.

However, manufacturing processes for multilayer stacked transistors and capacitors are complex. Especially in the process of manufacturing stacked transistors or capacitors, the wafer warpage is large in the process of forming stacked bodies, and it is difficult to control the process. Therefore, the process flow needs to be optimized urgently, and the device yield also needs to be improved urgently.

### SUMMARY

According to a first aspect of embodiments of the present disclosure, a semiconductor structure is provided, including:
a substrate;
a stacked structure located on the substrate, where the stacked structure includes multiple stacked units stacked in a direction perpendicular to a surface of the substrate, and each of the stacked units includes at least a stack of one memory cell member and one isolation structure; and
a stress adjustment layer located between the stacked structure and the substrate. The stress adjustment layer includes a first silicon germanium layer.

The first silicon germanium layer is made of a material including germanium-doped silicon, with a germanium content being a first component ratio. The first component ratio is linearly correlated with a ratio of a thickness of the memory cell member or a thickness of the isolation structure to a thickness of the stacked unit. A direction of thickness is a direction perpendicular to the surface of the substrate.

In some embodiments, the first component ratio ranges from 3% to 20%.

In some embodiments, the first silicon germanium layer has a thickness greater than or equal to 3 microns.

In some embodiments, the stress adjustment layer further includes a germanium base layer, and the germanium base layer is located between the substrate and the first silicon germanium layer.

In some embodiments, the germanium base layer is made of a material including silicon-doped germanium, with a germanium content ranging from 50% to 100%.

In some embodiments, the germanium base layer has a thickness ranging from 5 nanometers to 100 nanometers, and the first silicon germanium layer has a thickness ranging from 100 nanometers to 500 nanometers.

In some embodiments, the stacked structure further includes a second silicon germanium layer, and the second silicon germanium layer is located in the stacked unit, which is closest to the substrate, in the stacked structure.

In some embodiments, the second silicon germanium layer is made of a material including germanium-doped silicon, with a germanium content being a second component ratio. The second component ratio is greater than the first component ratio, and the first component ratio is linearly correlated with the second component ratio.

In some embodiments, the second component ratio ranges from 3.2% to 30%.

In some embodiments, the memory cell members are capacitor structures, and the semiconductor structure further includes: transistor structures located at one end of the stacked structure, where first source/drain regions of the transistor structures are connected to the capacitor structures in a one-to-one correspondence; word line structures, where the word line structures are connected to channel regions of the transistor structures; and bit line structures, where the bit line structures are connected to second source/drain regions of the transistor structures. Alternatively, the memory cell members are bit line structures, and the semiconductor structure further includes: transistor structures located at one end of the stacked structure, where second source/drain regions of the transistor structures are connected to the bit line structures; word line structures, where the word line structures are connected to channel regions of the transistor structures; and capacitor structures, where the capacitor structures are connected to first source/drain regions of the transistor structures in a one-to-one correspondence.

According to a second aspect of embodiments of the present disclosure, a manufacturing method for a semiconductor structure is provided, including the steps as follows.

A substrate is provided.

A stress adjustment layer is formed on the substrate, where the stress adjustment layer includes a first silicon germanium layer.

An initial stacked structure is formed on the stress adjustment layer. The initial stacked structure includes multiple initial stacked units stacked in a direction perpendicular to a surface of the substrate, and each of the initial stacked units includes at least a stack of one silicon layer and one second silicon germanium layer.

The second silicon germanium layers in the initial stacked structure are replaced with isolation structures, and part of the silicon layers are replaced with memory cell members to form a stacked structure. The stacked structure includes multiple stacked units stacked in a direction perpendicular to the surface of the substrate, and each of the stacked units includes at least a stack of one of the memory cell members and one of the isolation structures.

The first silicon germanium layer is made of a material including germanium-doped silicon, with a germanium content being a first component ratio. The first component ratio is linearly correlated with a ratio of a thickness of the memory cell member or a thickness of the isolation structure to a thickness of the stacked unit, and a direction of thickness is a direction perpendicular to the surface of the substrate.

In some embodiments, that a stress adjustment layer is formed on the substrate, where the stress adjustment layer includes a first silicon germanium layer includes the steps as follows. The first silicon germanium layer is grown on the surface of the substrate by utilizing an epitaxial growth method, where the first silicon germanium layer has a thickness greater than 3 microns, and the first component ratio ranges from 3% to 20%.

In some embodiments, that a stress adjustment layer is formed on the substrate, where the stress adjustment layer includes a first silicon germanium layer and a germanium base layer includes the steps as follows. The germanium base layer is grown on the surface of the substrate by utilizing an epitaxial growth method, and the first silicon germanium layer is grown on a surface of the germanium base layer by utilizing the epitaxial growth method. The germanium base layer is made of a material including silicon-doped germanium, with a germanium content ranging from 50% to 100%. The germanium base layer has a thickness ranging from 5 nanometers to 100 nanometers, and the first silicon germanium layer has a thickness ranging from 100 nanometers to 500 nanometers.

In some embodiments, that an initial stacked structure is formed on the stress adjustment layer includes the steps as follows. The multiple silicon layers and the multiple second silicon germanium layers are grown alternately on a surface of the first silicon germanium layer by utilizing an epitaxial growth method, to form the multiple initial stacked units stacked in the direction perpendicular to the surface of the substrate. Each of the initial stacked units includes at least a stack of one of the silicon layers and one of the second silicon germanium layers. The second silicon germanium layer is made of a material including germanium-doped silicon, with a germanium content being a second component ratio. The second component ratio is greater than the first component ratio, and the first component ratio is linearly correlated with the second component ratio. The second component ratio ranges from 3.2% to 30%.

In some embodiments, the memory cell members are capacitor structures, and the manufacturing method for a semiconductor structure further includes the steps as follows. Transistor structures located at one end of the initial stacked structure or the stacked structure are formed, where first source/drain regions of the transistor structures are connected to the capacitor structures in a one-to-one correspondence. Word line structures are formed, where the word line structures are connected to channel regions of the transistor structures. Bit line structures are formed, where the bit line structures are connected to second source/drain regions of the transistor structures. Alternatively, the memory cell members are bit line structures, and the manufacturing method for a semiconductor structure further includes the steps as follows. Transistor structures located at one end of the stacked structure are formed, where second source/drain regions of the transistor structures are connected to the bit line structures. Word line structures are formed, where the word line structures are connected to channel regions of the transistor structures. Capacitor structures are formed, where the capacitor structures are connected to first source/drain regions of the transistor structures in a one-to-one correspondence.

### BRIEF DESCRIPTION OF DRAWINGS

FIG. 1 to FIG. 7 are schematic diagrams of steps of forming a stacked semiconductor structure according to related technologies;
FIG. 8 to FIG. 14 are schematic diagrams of forming a semiconductor structure according to an example embodiment;
FIG. 15 to FIG. 21 are schematic diagrams of forming a semiconductor structure according to another example embodiment;
FIG. 22 is a schematic diagram of forming memory cell members according to an example embodiment;
FIG. 23 is a schematic diagram of forming memory cell members according to another example embodiment;
FIG. 24 is a schematic diagram of forming a 3D DRAM according to an example embodiment; and
FIG. 25 is a schematic diagram of forming a 3D DRAM according to another example embodiment.

### DESCRIPTION OF EMBODIMENTS

The technical solutions of the present disclosure are further described below in detail with reference to the accompanying drawings and the embodiments. Although example implementation methods of the present disclosure are shown in the accompanying drawings, it should be understood that the present disclosure may be implemented in various forms without being limited by the implementations described herein. Instead, these implementations are provided to develop a more thorough understanding of the present disclosure and to fully convey the scope of the present disclosure to a person skilled in the art.

In the following paragraphs, the present disclosure is described more specifically by way of example with reference to the accompanying drawings. The advantages and features of the present disclosure will be clearer from the following description and claims. It should be noted that the accompanying drawings are presented in a highly simplified form and are not drawn to exact scale, and are merely intended to conveniently and clearly assist in describing the embodiments of the present disclosure.

It may be understood that meanings of "on", "over", and "above" in the present disclosure should be understood in the broadest sense, so that "on" means that it is "on" something with no intermediate feature or layer (that is, directly on something), and further includes the meaning that it is "on" something with an intermediate feature or layer.

In the embodiments of the present disclosure, the terms "first", "second", "third", and the like are intended to distinguish between similar objects but do not necessarily indicate a specific order or sequence.

In the embodiments of the present disclosure, the term "layer" refers to a material part including a region having a thickness. The layer may extend over the whole of a lower or upper structure, or may have a range smaller than the range of the lower or upper structure. In addition, the layer may be a region of a homogeneous or heterogeneous continuous structure whose thickness is less than the thickness of a continuous structure. For example, the layer may be located between a top surface and a bottom surface of the continuous structure, or the layer may be located between any horizontal surface pair at the top surface and the bottom surface of the continuous structure. The layer may extend horizontally, vertically, and/or along an inclined surface. The layer may include multiple sublayers.

It should be noted that the technical solutions described in the embodiments of the present disclosure may be arbitrarily combined when there is no conflict.

In related technologies, in a manufacturing process for a 3D memory structure, a stacked body of a sacrificial material usually needs to be formed first, then the sacrificial material in the stacked body is removed through lateral etching by forming a hole or a trench in the middle or a side edge of the stacked body, and then a target material is filled as an alternative. To meet requirements for high performance of a device, a stacked body with a sacrificial material is usually formed on a wafer by utilizing an epitaxial growth method. However, the inventors of this application have found that with the increase of the number of layers of stacked bodies, the warpage problem of the wafer becomes increasingly obvious due to a lattice difference between the sacrificial material and a wafer material, which easily leads to instability of the process, or problems such as wafer fragment and product scrap in a severe case.

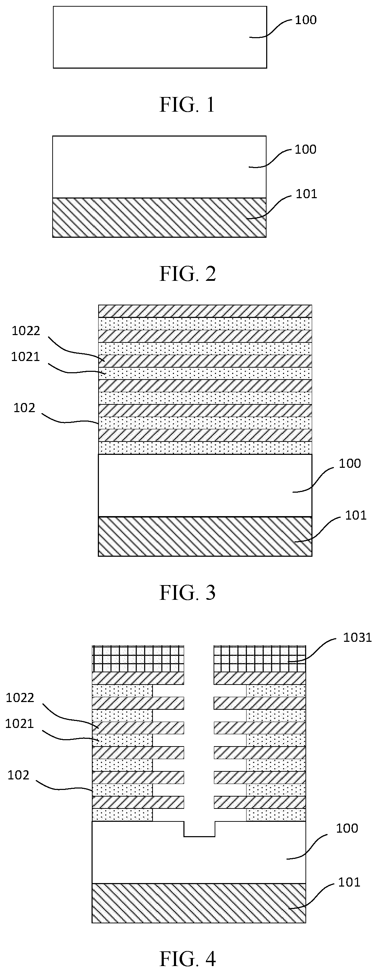

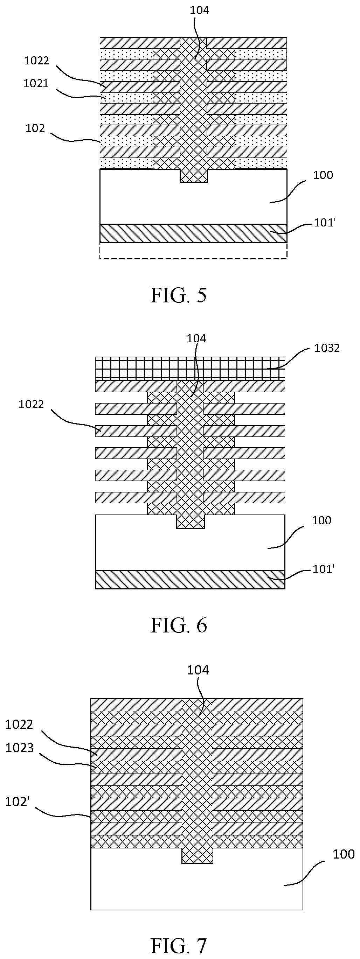

In related technologies, a solution for solving the warpage problem of the wafer is provided. As shown in FIG. 1 to FIG. 7, a warpage compensation layer 101 (usually made of silicon nitride) is first attached to a back surface of a wafer 100, and then a stacked structure 102 is epitaxially grown on a front surface of the wafer 100. The stacked structure 102 includes sacrificial layers 1021 and functional layers 1022, and then a first mask 1031 is formed on a top surface of the stacked structure 102. A trench is formed in the stacked structure 102 through the first mask 1031, and part of the sacrificial layers 1021 are removed through the trench. An alternative material 104 is filled, and part of the warpage compensation layer 101 located on the back surface of the wafer 100 is removed while the first mask 1031 is removed. Part of the warpage compensation layer 101' is retained. A second mask 1032 is formed on the top surface of the stacked structure 102, and a trench is formed in the stacked structure 102 through the second mask 1032. The remaining sacrificial layers 1021 are removed, and the alternative material 104 is filled. The remaining warpage compensation layer 101' located on the back surface of the wafer 100 is removed while the second mask 1032 is removed, and a required semiconductor structure is formed subsequently. The inventors of this application have found that in the above-mentioned related technologies, the method for forming the warpage compensation layer on the backside and then removing the warpage compensation layer involves multiple backside processes, wafer flipping, and other problems. The process steps are cumbersome, the process difficulty is high, and costs are high.

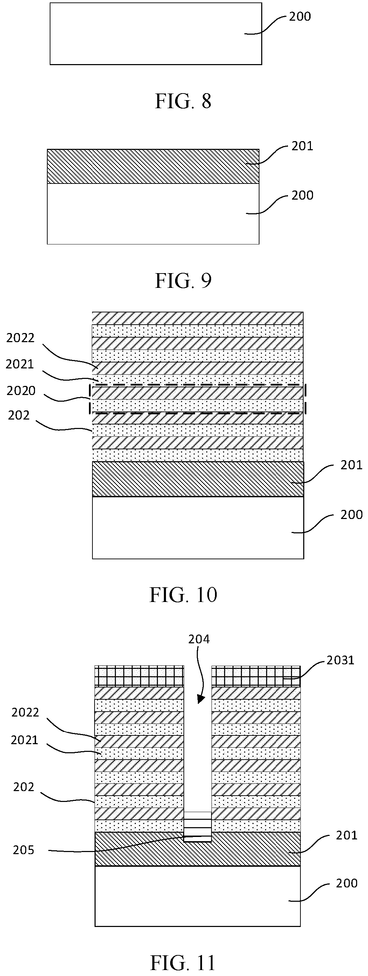

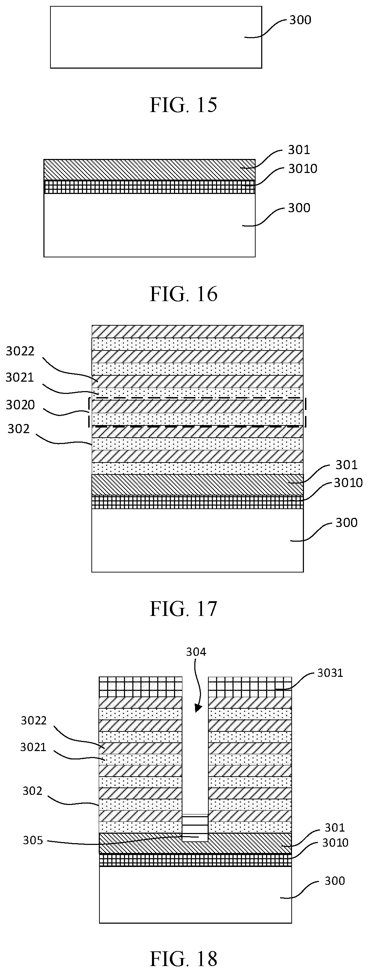

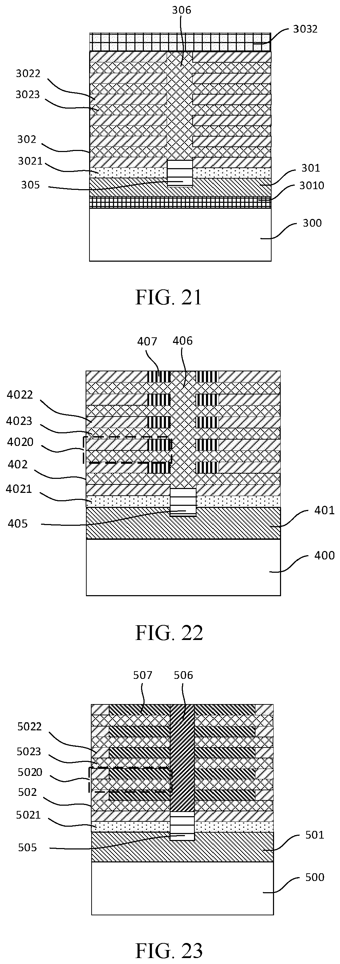

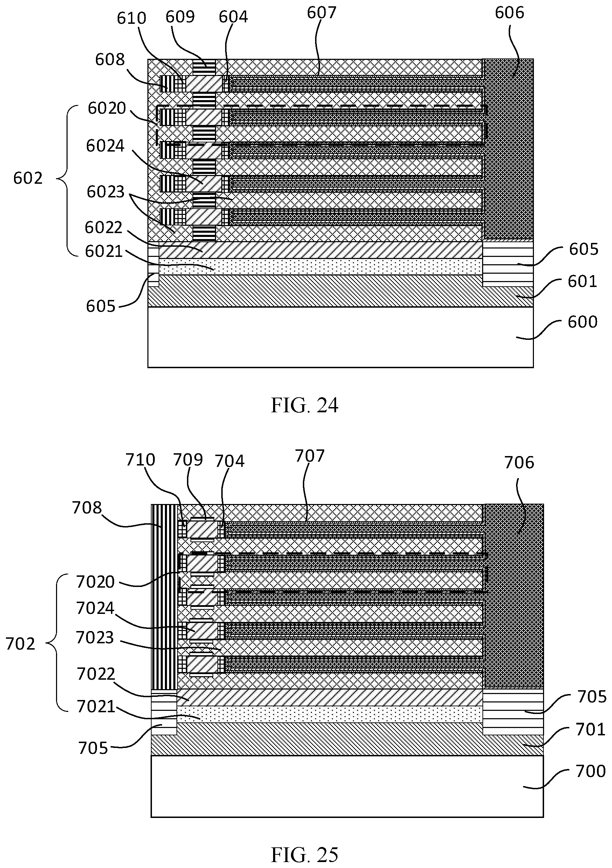

In view of the above-mentioned technical problems, the present disclosure provides a semiconductor structure and a manufacturing method therefor. The semiconductor structure and the manufacturing method therefor provided in the present disclosure as examples are specifically described below with reference to FIG. 8 to FIG. 25. FIG. 8 to FIG. 14 are schematic diagrams of steps of a manufacturing method for a semiconductor structure and a structure of the semiconductor structure according to an example embodiment of the present disclosure. FIG. 15 to FIG. 21 are schematic diagrams of steps of a manufacturing method for a semiconductor structure and a structure of the semiconductor structure according to another example embodiment of the present disclosure. FIG. 23 and FIG. 24 are schematic structural diagrams of forming memory cell members according to multiple example embodiments of the present disclosure. FIG. 24 and FIG. 25 are schematic structural diagrams of a 3D DRAM according to multiple example embodiments of the present disclosure.

In an example embodiment of the present disclosure, referring to FIG. 8, a substrate 200 is provided.

The substrate 200 may be made of at least one of the following materials: silicon, germanium, silicon germanium (SiGe), silicon on insulator (SOI), stacked silicon on insulator (SSOI), stacked silicon germanium on insulator (S-SiGeOI), silicon germanium on insulator (SiGeOI), germanium on insulator (GeOI), and other semiconductor materials or III-V materials. In an example embodiment of the present disclosure, the substrate 200 is made of monocrystalline silicon.

Referring to FIG. 9, a stress adjustment layer is formed on the substrate 200. In an example embodiment of the present disclosure, the stress adjustment layer includes a first silicon germanium layer 201.

The first silicon germanium layer 201 is made of a material including germanium-doped silicon, with a germanium content being a first component ratio Y. In some embodiments, the first component ratio Y ranges from 3% to 20%. It should be noted that, the germanium content being the first component ratio described herein should be understood as a ratio of the number of germanium atoms in the silicon germanium layer to the total number of all atoms (mainly silicon atoms and germanium atoms) in the silicon germanium layer.

The first silicon germanium layer 201 is formed on a front surface of the substrate 200, and in some embodiments, the first silicon germanium layer 201 has a thickness not less than 3 µm (micrometers). In another embodiment, the first silicon germanium layer 201 has a thickness greater than 3 µm and less than or equal to 10 µm. The thickness of the first silicon germanium layer 201 should not be too small. If the thickness is too small, a warpage adjustment effect is not good. The thickness should not be too large, and if the thickness is too large, overcorrection occurs in terms of the warpage adjustment effect. It should be noted that the front surface described herein refers to a functional surface of the wafer, and a required functional device is formed on the functional surface subsequently.

In an example embodiment of the present disclosure, the first silicon germanium layer 201 is formed on the front surface of the substrate 200 by utilizing an epitaxial growth method. Specifically, process conditions of the epitaxial growth are as follows: The temperature range is controlled at 600°C to 700°C, the pressure range is controlled at 5 torr to 50 torr, and a silicon source gas and a germanium source gas are introduced into the substrate 200. In some embodiments, dichlorosilane (SiH₂Cl₂) is employed as the silicon source gas, and germane (GeH₄) is employed as the germanium source gas. In some other embodiments, silane (SiH₄) is employed as the silicon source gas, and germane (GeH₄) is employed as the germanium source gas. The silicon source gas and the germanium source gas each have a flow rate ranging from 20 sccm to 200 sccm (standard cubic centimeters per minute).

In an example embodiment of the present disclosure, after the first silicon germanium layer 201 is epitaxially grown on the substrate 200, high-temperature annealing is performed, so that crystal dislocations between the first silicon germanium layer 201 and the substrate 200 are pressed at an interface, and stress in the first silicon germanium layer 201 is fully released. In some embodiments, the temperature for the high-temperature annealing ranges from 950°C to 1050°C, and the high-temperature annealing is performed for a time ranging from 3 minutes to 10 minutes.

In an example embodiment of the present disclosure, referring to FIG. 10, an initial stacked structure 202 is formed on the stress adjustment layer.

In an example embodiment of the present disclosure, a method for forming the initial stacked structure 202 includes the steps as follows: With a silicon germanium (SiGe) surface of the first silicon germanium layer 201 as an initial base layer, an initial stacked structure 202 with silicon-silicon germanium (Si-SiGe) alternately stacked is grown on the first silicon germanium layer 201 by utilizing an epitaxial growth method, with a stacking direction being a direction perpendicular to the surface of the substrate 200. A second silicon germanium layer may be formed by adding a germanium source gas during epitaxial growth of a silicon layer. The initial stacked structure 202 includes multiple initial stacked units 2020, and each of the initial stacked units 2020 includes at least a stack of one silicon layer 2022 and one second silicon germanium layer 2021.

In some embodiments, the number of the second silicon germanium layers 2021 and the number of the silicon layers 2022 in the initial stacked structure 202 are the same, and are both greater than or equal to 5. In some other embodiments, the number of the second silicon germanium layers 2021 is 1 more than the number of the silicon layers 2022 in the initial stacked structure 202.

In some embodiments, a top layer of the initial stacked structure 202, namely a layer, which is farthest from the first silicon germanium layer 201, of the initial stacked structure 202 is a second silicon germanium layer 2021, and is subsequently replaced with an insulating material, which may be configured to protect the silicon layers 2022 below the insulating material, and possible damage to memory cell members formed subsequently is reduced in a subsequent manufacturing process. In some embodiments, a top layer of the initial stacked structure 202, namely a layer, which is farthest from the first silicon germanium layer 201, of the initial stacked structure 202 may alternatively be a silicon layer 2022, but a mask layer formed subsequently covers the top layer to also provide protection.

In some embodiments, the second silicon germanium layer 2021 in the initial stacked structure 202 is made of a material including germanium-doped silicon, with a germanium content being a second component ratio X. In the process of epitaxial growth to form the second silicon germanium layer 2021, the germanium content in the second silicon germanium layer 2021 may be controlled by controlling a supply ratio of the silicon source gas to the germanium source gas. The second component ratio X ranges from 3.2% to 30%. In some embodiments, the germanium content (second component ratio X) in the second silicon germanium layer 2021 is greater than the germanium content (first component ratio Y) in the first silicon germanium layer 201, and the first component ratio Y is linearly correlated with the second component ratio X. It should be noted that, that the germanium content in the second silicon germanium layer 2021 is the second component ratio X, which is described herein, should be understood as being similar to the description that the germanium content in the first silicon germanium layer 201 is the first component ratio Y in the above-mentioned embodiment. Repeated descriptions are not provided herein.

In some embodiments, an initial stacked unit 2020 of the initial stacked structure 202 includes only a single second silicon germanium layer 2021 and a single silicon layer 2022. The single second silicon germanium layer 2021 has a thickness of A, and the single silicon layer 2022 has a thickness of B. A or B ranges from 50 nm to 150 nm. The germanium content (first component ratio Y) in the first silicon germanium layer 201 is linearly correlated with the ratio of the thickness A of the second silicon germanium layer 2021 or the thickness B of the single silicon layer 2022 to the thickness of the initial stacked unit 2020. In some embodiments, the germanium content (first component ratio Y) in the first silicon germanium layer 201 is linearly and positively correlated with the ratio of the thickness A of the second silicon germanium layer 2021 to the thickness of the initial stacked unit 2020. In an example embodiment of the present disclosure, the first component ratio Y, the second component ratio X, the thickness A of the single second silicon germanium layer 2021, and the thickness B of the single silicon layer 2022 satisfy the following relationship: $Y = X ∗ \frac{A}{A + B}$

It should be noted that the direction of thickness described herein should be understood as a direction perpendicular to the surface of the substrate 200. The first silicon germanium layer 201 satisfying the above-mentioned relationship may be in a partially or completely relaxed state. In some embodiments, after the initial stacked structure 202 is epitaxially grown on the first silicon germanium layer 201 under basically the same process conditions, the warpage (warpage) of the entire wafer changes less than 10 µm, and with the increase of the number of epitaxial layers, a warpage change rate is less than 50%.

In an example embodiment of the present disclosure, after the initial stacked structure 202 is formed on the first silicon germanium layer 201, as shown in FIG. 11, a trench 204 is formed in the initial stacked structure 202, and the trench 204 runs through the initial stacked structure 202. In some embodiments, the bottom of the trench 204 stops in the first silicon germanium layer 201.

Specifically, in some embodiments, the step of forming the trench 204 includes the substeps as follows. A first mask layer 2031 is first formed on the top layer of the initial stacked structure 202, and the first mask layer 2031 is patterned to form an opening, with the bottom of the opening exposing part of the top surface of the initial stacked structure 202 as an area to be etched. Then the initial stacked structure 202 is etched along the opening, and the entire initial stacked structure 202 is etched through. In some embodiments, the etching method may be at least one of the following etching methods: plasma dry etching, ion beam etching (IBE), and reactive ion etching (RIE). In some embodiments, the bottom of the trench 204 obtained through etching stops in the first silicon germanium layer 201 in an etching end-point detection (EPD) mode.

In some embodiments, the first mask layer 2031 may be made of one or a combination of more of photoresist, spin-on hardmask (SOH), spin-on carbon (SOC), amorphous carbon, polysilicon, silicon nitride, silicon oxynitride, and silicon carbonitride.

In an example embodiment of the present disclosure, after the trench 204 is formed to run through the initial stacked structure 202, a protective layer 205 is formed at the bottom of the trench 204.

In some embodiments, a top surface of the protective layer 205 is not lower than the top surface of the second silicon germanium layer 2021 located at a bottom layer (namely a single layer closest to the substrate 200) in the initial stacked structure 202, and the top surface of the protective layer 205 needs to be lower than the top surface of the second silicon germanium layer 2021 located above the bottom layer and closest to the bottom layer (namely a second closest single layer to the substrate 200) in the initial stacked structure 202.

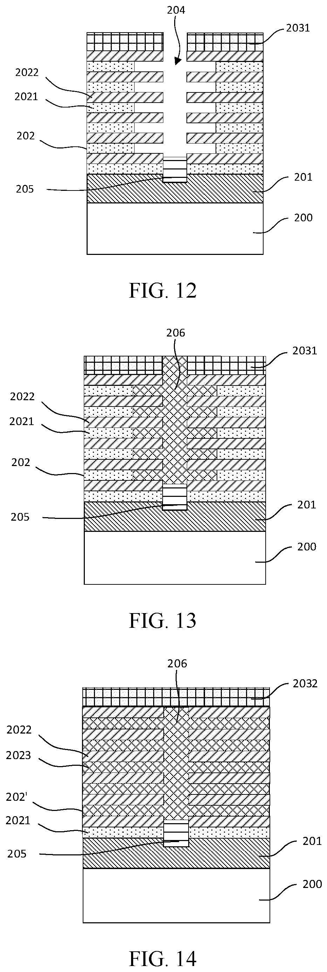

In an example embodiment of the present disclosure, after the trench 204 and the protective layer 205 are formed, as shown in FIG. 12, through end surfaces of the second silicon germanium layers 2021 in the initial stacked structure 202 that are exposed by the trench 204, lateral etching (lateral etch) is performed on the second silicon germanium layers 2021, to selectively remove part of the second silicon germanium layers 2021 in the initial stacked structure 202 and form gaps between the retained adjacent silicon layers 2022. Lateral etching directions extend away from the trench 204.

In some embodiments, the second silicon germanium layers 2021 are laterally etched by utilizing a silicon germanium etching solution. Specifically, the silicon germanium etching solution may include a mixed solution of hydrofluoric acid (HF), hydrogen peroxide (H₂O₂), and a silicon corrosion inhibitor.

In some embodiments, in the lateral etching process, because the protective layer 205 has a low etching selectivity ratio to the second silicon germanium layers 2021 and covers the end surfaces of the second silicon germanium layer 2021 at the bottom layer (namely the single layer closest to the substrate 200) in the initial stacked structure 202, the second silicon germanium layer 2021 at the bottom layer is not in contact with the etching solution, and therefore is not etched.

In an example embodiment of the present disclosure, after part of the second silicon germanium layers 2021 are removed, as shown in FIG. 13, the trench 204 is filled with an isolation material 206, and the isolation material 206 fills the trench 204 and the gaps between the adjacent silicon layers 2022 after the aforementioned lateral etching.

In some embodiments, the isolation material 206 may be at least one or any combination of the following materials: silicon oxide, silicon nitride, silicon oxynitride, silicon carbide, silicon carbonitride, and silicon oxycarbonitride. In an example embodiment of the present disclosure, silicon oxide is employed as the isolation material 206.

In an example embodiment of the present disclosure, after the isolation material 206 fills the trench 204 and the gaps between the adjacent silicon layers 2022 upon the aforementioned lateral etching, another trench (not shown, only positionally different from the trench 204) is formed at another position in the initial stacked structure 202, and the remaining second silicon germanium layers 2021 are removed through the another trench. Specifically, as shown in FIG. 14, a second mask layer 2032 is formed, and the second mask layer 2032 may be made of the same material as the first mask layer 2031. The second mask layer 2032 is patterned to form an opening, and part of the top surface of the initial stacked structure 202 is exposed at the bottom of the opening as an area to be etched. The initial stacked structure 202 is etched along the opening to form another trench (not shown), which runs through the entire initial stacked structure 202. The same protective layer 205 is formed at the bottom of the another trench (not shown). Through end surfaces of the second silicon germanium layers 2021 in the initial stacked structure 202 that are exposed by the another trench (not shown), lateral etching is performed on the second silicon germanium layers 2021, to selectively remove the remaining second silicon germanium layers 2021 in the initial stacked structure 202 and form remaining gaps between the retained adjacent silicon layers 2022. Lateral etching directions extend away from the another trench (not shown). After the remaining second silicon germanium layers 2021 are removed, the another trench (not shown) is filled with an isolation material 206, and the isolation material 206 fills the another trench (not shown) and the remaining gaps between the adjacent silicon layers 2022 after the aforementioned lateral etching.

In some embodiments, the trench 204 and the another trench (not shown) may be formed in the same etching step. That is, the first mask layer 2031 and the second mask layer 2032 are the same mask layer, multiple openings are formed through patterning, bottoms of the multiple openings expose part of the top surface of the initial stacked structure, which is employed as an area to be etched for the trench 204 and the another trench (not shown), and then the trench 204 and the another trench (not shown) are etched along the multiple openings. It may be understood that in some embodiments, the subsequent selective removal of the second silicon germanium layers 2021 in the initial stacked structure 202 through the trench 204 and the another trench (not shown) may alternatively be completed in the same etching step, and in some embodiments, the subsequent filling with the isolation material 206 may alternatively be performed in the same filling step. In the above-mentioned embodiment, there is no need to remove the previously formed patterned first mask layer 2031 located on the top layer of the initial stacked structure 202, then form the second mask layer 2032 on the top layer of the initial stacked structure 202, and then pattern the second mask layer 2032, thereby reducing photolithography steps, and the subsequent selective removal of the second silicon germanium layers 2021 and the filling with the isolation material 206 also reduce similar process steps, thereby greatly reducing process costs, reducing process difficulty, and also reducing damage to the surface of the top layer of the initial stacked structure 202 in the process of removing the first mask layer 2031 and the second mask layer 2032 and corrosion and consumption of the silicon layers 2022 by the etching solution in the multi-step lateral etching process.

In another example embodiment of the present disclosure, referring to FIG. 15, a substrate 300 is provided.

The substrate 300 may be made of at least one of the following materials: silicon, germanium, silicon germanium (SiGe), silicon on insulator (SOI), stacked silicon on insulator (SSOI), stacked silicon germanium on insulator (S-SiGeOI), silicon germanium on insulator (SiGeOI), germanium on insulator (GeOI), and other semiconductor materials or III-V materials. In an example embodiment of the present disclosure, the substrate 300 is made of monocrystalline silicon.

Referring to FIG. 16, a stress adjustment layer is formed on the substrate 300. In an example embodiment of the present disclosure, the stress adjustment layer includes a first silicon germanium layer 301 and a germanium base layer 3010.

The first silicon germanium layer 301 is made of a material including germanium-doped silicon, with a germanium content being a first component ratio Y. In some embodiments, the first component ratio Y ranges from 3% to 20%. It should be noted that, the germanium content being the first component ratio described herein should be understood as a ratio of the number of germanium atoms in the silicon germanium layer to the total number of all atoms (mainly silicon atoms and germanium atoms) in the silicon germanium layer.

The germanium base layer 3010 is made of a material including silicon-doped germanium, with a germanium content being a third component ratio Z. In some embodiments, the third component ratio Z ranges from 50% to 100%. That the germanium content in the germanium base layer 3010 is the third component ratio Z, which is described herein, should be understood as being similar to the description that the germanium content in the first silicon germanium layer 301 is the first component ratio Y in the above-mentioned embodiment. Repeated descriptions are not provided herein.

The germanium base layer 3010 is formed on the front surface of the substrate 300, and the first silicon germanium layer 301 is formed on the germanium base layer 3010. In some embodiments, the germanium base layer 3010 has a thickness ranging from 5 nm (nanometers) to 100 nm (nanometers), and the first silicon germanium layer 301 has a thickness ranging from 100 nm (nanometers) to 500 nm (nanometers). The thickness of the first silicon germanium layer 301 should not be too small. If the thickness is too small, a warpage adjustment effect is not good. The thickness should not be too large, and if the thickness is too large, overcorrection occurs in terms of the warpage adjustment effect. It should be noted that the front surface described herein refers to a functional surface of the wafer, and a required functional device is formed on the functional surface subsequently.

In another example embodiment of the present disclosure, the germanium base layer 3010 is formed on the surface of the substrate 300 by utilizing an epitaxial growth method. Specifically, process conditions of the epitaxial growth are as follows: The temperature range is controlled at 300°C to 650°C, the pressure range is controlled at 5 torr to 50 torr, and a silicon source gas and a germanium source gas are introduced into the substrate 300. In some embodiments, silane (SiH₄) is employed as the silicon source gas, and germane (GeH₄) is employed as the germanium source gas. The silicon source gas and the germanium source gas each have a flow rate ranging from 20 sccm to 200 sccm (standard cubic centimeters per minute).

In another example embodiment of the present disclosure, the first silicon germanium layer 301 is formed on the surface of the germanium base layer 3010 by utilizing an epitaxial growth method. Specifically, process conditions of the epitaxial growth are as follows: The temperature range is controlled at 600°C to 700°C, the pressure range is controlled at 5 torr to 50 torr, and a silicon source gas and a germanium source gas are introduced into the substrate 300. In some embodiments, dichlorosilane (SiH₂Cl₂) is employed as the silicon source gas, and germane (GeH₄) is employed as the germanium source gas. In some other embodiments, silane (SiH₄) is employed as the silicon source gas, and germane (GeH₄) is employed as the germanium source gas. The silicon source gas and the germanium source gas each have a flow rate ranging from 20 sccm to 200 sccm (standard cubic centimeters per minute).

Compared with the aforementioned embodiment, the thickness of a combination of the first silicon germanium layer 301 and the germanium base layer 3010 is much smaller than that of the first silicon germanium layer 201 in the aforementioned embodiment, thereby reducing epitaxial costs, reducing the overall thickness of a wafer after subsequent epitaxial growth of the stacked structure, and greatly alleviating the warpage problem.

In another example embodiment of the present disclosure, after the germanium base layer 3010 and the first silicon germanium layer 301 are epitaxially grown on the substrate 300, high-temperature annealing is performed, so that crystal dislocations between the first silicon germanium layer 301 and the germanium base layer 3010 and between the germanium base layer 3010 and the substrate 300 are pressed at an interface, and stress in the first silicon germanium layer 301 and the germanium base layer 3010 is fully released. In some embodiments, the temperature for the high-temperature annealing ranges from 950°C to 1050°C, and the high-temperature annealing is performed for a time ranging from 3 minutes to 10 minutes.

In another example embodiment of the present disclosure, referring to FIG. 17, an initial stacked structure 302 is formed on the stress adjustment layer.

In another example embodiment of the present disclosure, a method for forming the initial stacked structure 302 includes the steps as follows: With a silicon germanium (SiGe) surface of the first silicon germanium layer 301 as an initial base layer, an initial stacked structure 302 with silicon-silicon germanium (Si-SiGe) alternately stacked is grown on the first silicon germanium layer 301 by utilizing an epitaxial growth method, with a stacking direction being a direction perpendicular to the surface of the substrate 300. A second silicon germanium layer may be formed by adding a germanium source gas during epitaxial growth of a silicon layer. The initial stacked structure 302 includes multiple initial stacked units 3020, and each of the initial stacked units 3020 includes at least a stack of one silicon layer 3022 and one second silicon germanium layer 3021.

In some embodiments, the number of the second silicon germanium layers 3021 and the number of the silicon layers 3022 in the initial stacked structure 302 are the same, and are both greater than or equal to 5. In some other embodiments, the number of the second silicon germanium layers 3021 is 1 more than the number of the silicon layers 3022 in the initial stacked structure 302.

In some embodiments, a top layer of the initial stacked structure 302, namely a layer, which is farthest from the first silicon germanium layer 301, of the initial stacked structure 302 is a second silicon germanium layer 3021, and is subsequently replaced with an insulating material, which may be configured to protect the silicon layers 3022 below the insulating material, and possible damage to memory cell members formed subsequently is reduced in a subsequent manufacturing process. In some embodiments, a top layer of the initial stacked structure 302, namely a layer, which is farthest from the first silicon germanium layer 301, of the initial stacked structure 302 may alternatively be a silicon layer 3022, but a mask layer formed subsequently covers the top layer to also provide protection.

In some embodiments, the second silicon germanium layer 3021 in the initial stacked structure 302 is made of a material including germanium-doped silicon, with a germanium content being a second component ratio X. In the process of epitaxial growth to form the second silicon germanium layer 3021, the germanium content in the second silicon germanium layer 3021 may be controlled by controlling a supply ratio of the silicon source gas to the germanium source gas. The second component ratio X ranges from 3.2% to 30%. In some embodiments, the germanium content (second component ratio X) in the second silicon germanium layer 3021 is greater than the germanium content (first component ratio Y) in the first silicon germanium layer 301, and the first component ratio Y is linearly correlated with the second component ratio X. It should be noted that, that the germanium content in the second silicon germanium layer 3021 is the second component ratio X, which is described herein, should be understood as being similar to the description that the germanium content in the first silicon germanium layer 301 is the first component ratio Y in the above-mentioned embodiment. Repeated descriptions are not provided herein.

In some embodiments, a single initial stacked unit 3020 of the initial stacked structure 302 includes only a single second silicon germanium layer 3021 and a single silicon layer 3022. The single second silicon germanium layer 3021 has a thickness of A, and the single silicon layer 3022 has a thickness of B. A or B ranges from 50 nm to 150 nm. The germanium content (first component ratio Y) in the first silicon germanium layer 301 is linearly correlated with the ratio of the thickness A of the single second silicon germanium layer 3021 or the thickness B of the single silicon layer 3022 to the thickness of the initial stacked unit 3020. In some embodiments, the germanium content (first component ratio Y) in the first silicon germanium layer 301 is linearly and positively correlated with the ratio of the thickness A of the single second silicon germanium layer 3021 to the thickness of the single initial stacked unit 3020. In an example embodiment of the present disclosure, the first component ratio Y, the second component ratio X, the thickness A of the single second silicon germanium layer 3021, and the thickness B of the single silicon layer 3022 satisfy the following relationship: $Y = X ∗ \frac{A}{A + B}$

It should be noted that the direction of thickness described herein should be understood as a direction perpendicular to the surface of the substrate 300. The first silicon germanium layer 301 satisfying the above-mentioned relationship may be in a partially or completely relaxed state. In some embodiments, after the initial stacked structure 302 is epitaxially grown on the first silicon germanium layer 301 under basically the same process conditions, the warpage (warpage) of the entire wafer changes less than 10 µm, and with the increase of the number of epitaxial layers, a warpage change rate is less than 50%.

In another example embodiment of the present disclosure, after the initial stacked structure 302 is formed on the first silicon germanium layer 301, as shown in FIG. 18, a trench 304 is formed in the initial stacked structure 302, and the trench 304 runs through the initial stacked structure 302. In some embodiments, the bottom of the trench 304 stops in the first silicon germanium layer 301.

Specifically, in some embodiments, the step of forming the trench 304 includes the substeps as follows. A first mask layer 3031 is first formed on the top layer of the initial stacked structure 202, and the first mask layer 3031 is patterned to form an opening, with the bottom of the opening exposing part of the top surface of the initial stacked structure 302 as an area to be etched. The initial stacked structure 302 is etched along the opening, and the entire initial stacked structure 302 is etched through. In some embodiments, the etching method may be at least one of the following etching methods: plasma dry etching, ion beam etching (IBE), and reactive ion etching (RIE). In some embodiments, the bottom of the trench 304 obtained through etching stops in the first silicon germanium layer 301 in an etching end-point detection (EPD) mode.

In some embodiments, the first mask layer 3031 may be made of one or a combination of more of photoresist, spin-on hardmask (SOH), spin-on carbon (SOC), amorphous carbon, polysilicon, silicon nitride, silicon oxynitride, and silicon carbonitride.

In another example embodiment of the present disclosure, after the trench 304 is formed to run through the initial stacked structure 302, a protective layer 305 is formed at the bottom of the trench 304.

In some embodiments, a top surface of the protective layer 305 is not lower than the top surface of the second silicon germanium layer 3021 located at a bottom layer (namely a single layer closest to the substrate 300) in the initial stacked structure 302, and the top surface of the protective layer 305 needs to be lower than the top surface of the second silicon germanium layer 3021 located above the bottom layer and closest to the bottom layer (namely a second closest single layer to the substrate 300) in the initial stacked structure 302.

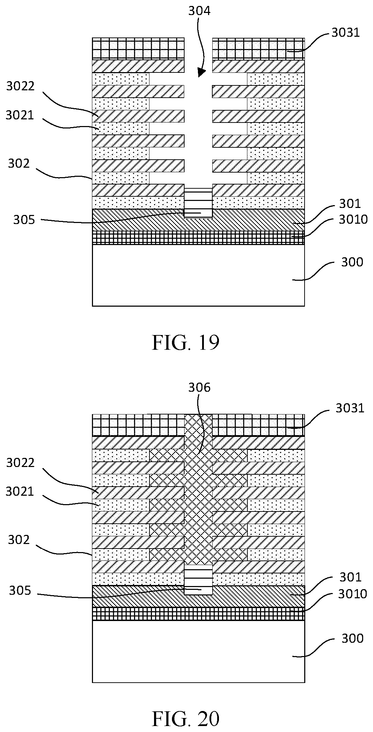

In another example embodiment of the present disclosure, after the trench 304 and the protective layer 305 are formed, as shown in FIG. 19, through end surfaces of the second silicon germanium layers 3021 in the initial stacked structure 302 that are exposed by the trench 304, lateral etching (lateral etch) is performed on the second silicon germanium layers 3021, to selectively remove part of the second silicon germanium layers 3021 in the initial stacked structure 302 and form gaps between the retained adjacent silicon layers 3022. Lateral etching directions extend away from the trench 304.

In some embodiments, the second silicon germanium layers 3021 are laterally etched by a silicon germanium etching solution. Specifically, the silicon germanium etching solution may include a mixed solution of hydrofluoric acid (HF), hydrogen peroxide (H₂O₂), and a silicon corrosion inhibitor.

In some embodiments, in the lateral etching process, because the protective layer 305 has a low etching selectivity ratio to the second silicon germanium layers 3021 and covers the end surfaces of the second silicon germanium layer 3021 at the bottom layer (namely the single layer closest to the substrate 300) in the initial stacked structure 302, the second silicon germanium layer 3021 at the bottom layer is not in contact with the etching solution, and therefore is not etched.

In another example embodiment of the present disclosure, after part of the second silicon germanium layers 3021 are removed, as shown in FIG. 20, the trench 304 is filled with an isolation material 306, and the isolation material 306 fills the trench 304 and the gaps between the adjacent silicon layers 3022 after the aforementioned lateral etching.

In some embodiments, the isolation material 306 may be at least one or any combination of the following materials: silicon oxide, silicon nitride, silicon oxynitride, silicon carbide, silicon carbonitride, and silicon oxycarbonitride. In an example embodiment of the present disclosure, silicon oxide is employed as the isolation material 306.

In another example embodiment of the present disclosure, after the isolation material 306 fills the trench 304 and the gaps between the adjacent silicon layers 3022 upon the aforementioned lateral etching, another trench (not shown, only positionally different from the trench 304) is formed at another position in the initial stacked structure 302, and the remaining second silicon germanium layers 3021 are removed through the another trench. Specifically, as shown in FIG. 21, a second mask layer 3032 is formed, and the second mask layer 3032 may be made of the same material as the first mask layer 3031. The second mask layer 3032 is patterned to form an opening, and part of the top surface of the initial stacked structure 302 is exposed at the bottom of the opening as an area to be etched. The initial stacked structure 302 is etched along the opening to form another trench (not shown), which runs through the entire initial stacked structure 302. The same protective layer 305 is formed at the bottom of the another trench (not shown). Through end surfaces of the second silicon germanium layers 3021 in the initial stacked structure 302 that are exposed by the another trench (not shown), lateral etching is performed on the second silicon germanium layers 3021, to selectively remove the remaining second silicon germanium layers 3021 in the initial stacked structure 302 and form remaining gaps between the retained adjacent silicon layers 3022. Lateral etching directions extend away from the another trench (not shown). After the remaining second silicon germanium layers 3021 are removed, the another trench (not shown) is filled with an isolation material 306, and the isolation material 306 fills the another trench (not shown) and the remaining gaps between the adjacent silicon layers 3022 after the aforementioned lateral etching.

In some embodiments, the trench 304 and the another trench (not shown) may be formed in the same etching step. That is, the first mask layer 3031 and the second mask layer 3032 are the same mask layer, multiple openings are formed through patterning, bottoms of the multiple openings expose part of the top surface of the initial stacked structure, which is employed as an area to be etched for the trench 304 and the another trench (not shown), and then the trench 304 and the another trench (not shown) are etched along the multiple openings. It may be understood that in some embodiments, the subsequent selective removal of the second silicon germanium layers 3021 in the initial stacked structure 302 through the trench 304 and the another trench (not shown) may alternatively be completed in the same etching step, and in some embodiments, the subsequent filling with the isolation material 306 may alternatively be performed in the same filling step. In the above-mentioned embodiment, there is no need to remove the previously formed patterned first mask layer 3031 located on the top layer of the initial stacked structure 302, then form the second mask layer 3032 on the top layer of the initial stacked structure 302, and then pattern the second mask layer 3032, thereby reducing photolithography steps, and the subsequent selective removal of the second silicon germanium layers 3021 and the filling with the isolation material 306 also reduce similar process steps, thereby greatly reducing process costs, reducing process difficulty, and also reducing damage to the surface of the top layer of the initial stacked structure 302 in the process of removing the first mask layer 3031 and the second mask layer 3032 and corrosion and consumption of the silicon layers 3022 by the etching solution in the multi-step lateral etching process.

In an example embodiment of the present disclosure, referring to FIG. 22 or FIG. 23, after the second silicon germanium layers 2021/3021 in the initial stacked structure 202/302 in the aforementioned embodiment are replaced with the isolation material 206/306, the silicon layers 2022/3022 in the initial stacked structure 202/302 are partially replaced with memory cell members, to form a stacked structure 402.

In an example embodiment of the present disclosure, as shown in FIG. 22, a stress adjustment layer 401 is formed on a substrate 400, and the stress adjustment layer 401 may be the same as the stress adjustment layer according to any one of the aforementioned embodiments. A stacked structure 402 is formed on the stress adjustment layer 401. The stacked structure 402 includes multiple stacked units 4020, and each of the stacked units 4020 includes at least a stack of one memory cell member 407 and one isolation structure 4023. The memory cell member 407 is a bit line structure, and is formed at one end of each silicon layer 4022 in the stacked structure 402. An isolation material 406 is located at one end of the memory cell member 407 away from the silicon layer 4022, fills the stacked structure 402, and is connected into a whole with the isolation structures 4023 between adjacent silicon layers 4022. In some embodiments, the stress adjustment layer 401 may be any one of the stress adjustment layers according to the aforementioned embodiments, which satisfies the corresponding same relationship in the aforementioned embodiments. Repeated descriptions are not provided herein.

In some embodiments, a method for forming the memory cell member 407 that is a bit line structure may include the steps as follows. One end of each of the silicon layers 2022/3022 in the initial stacked structure 202/302 of FIG. 14 or FIG. 21 in the aforementioned embodiment is partially laterally etched, and then bit line structures are formed by utilizing a metal deposition method. In some embodiments, an extension direction of the bit line structure is parallel to a surface of the substrate 400 and is perpendicular to an extension direction of the silicon layers 2022/3022. In some embodiments, a manufacturing method for a semiconductor structure according to the present disclosure further includes the steps as follows. Transistor structures located at one end of the stacked structure 402 are formed, where second source/drain regions of the transistor structures are connected to the bit line structures. Word line structures are formed, where the word line structures are connected to channel regions of the transistor structures. Capacitor structures are formed, where the capacitor structures are connected to the first source/drain regions of the transistor structures in a one-to-one correspondence.

In another example embodiment of the present disclosure, as shown in FIG. 23, a stress adjustment layer 501 is formed on a substrate 500, and the stress adjustment layer 501 may be the same as the stress adjustment layer according to any one of the aforementioned embodiments. A stacked structure 502 is formed on the stress adjustment layer 501. The stacked structure 502 includes multiple stacked units 5020, and each of the stacked units 5020 includes at least a stack of one memory cell member 507 and one isolation structure 5023. In some embodiments, the memory cell member 507 is a capacitor structure, and is formed at one end of each silicon layer 5022 in the stacked structure 502. An electrode material is located at one end of the memory cell member 507 away from the silicon layer 5022, fills the stacked structure 502, and is connected into a whole with an upper electrode (not shown) in the capacitor structure. In some other embodiments, the memory cell member 507 is a bit line contact structure, and is formed at one end of each silicon layer 5022 in the stacked structure 502. A bit line structure 506 is located at one end of each of the memory cell members 507 away from the silicon layer 5022, is formed in the stacked structure 502, and is connected into a whole with the bit line contact structure in a vertical direction (direction perpendicular to the surface of the substrate 500) of the same column. In some embodiments, the stress adjustment layer 501 may be any one of the stress adjustment layers according to the aforementioned embodiments, which satisfies the corresponding same relationship in the aforementioned embodiments. Repeated descriptions are not provided herein.

In some embodiments, a method for forming the memory cell member 507 that is a capacitor structure may include the steps as follows. One end of each of the silicon layers 2022/3022 in the initial stacked structure 202/302 of FIG. 14 or FIG. 21 in the aforementioned embodiment is laterally etched, and then a capacitor structure is formed by utilizing a deposition method, including forming a stack of a lower electrode, a dielectric, and an upper electrode. In some embodiments, an extension direction of the capacitor structure is parallel to the surface of the substrate 500 and is parallel to the extension direction of the silicon layers 2022/3022. In some embodiments, a manufacturing method for a semiconductor structure according to the present disclosure further includes the steps as follows. Transistor structures located at one end of the stacked structure 502 are formed, where first source/drain regions of the transistor structures are connected to the capacitor structures in a one-to-one correspondence. Word line structures are formed, where the word line structures are connected to channel regions of the transistor structures. Bit line structures are formed, where the bit line structures are connected to second source/drain regions of the transistor structures.

In some other embodiments, a method for forming the memory cell member 507 that is a bit line contact structure may include the steps as follows. One end of each of the silicon layers 2022/3022 in the initial stacked structure 202/302 of FIG. 14 or FIG. 21 in the aforementioned embodiment is exposed, then bit line contact structures are formed by utilizing a metallization method, and then a bit line structure 506 is formed to connect the bit line contact structure located in a vertical direction (direction perpendicular to the surface of the substrate 500) of the same column. In some embodiments, a manufacturing method for a semiconductor structure according to the present disclosure further includes the steps as follows. Transistor structures located at one end of the stacked structure 502 are formed, where second source/drain regions of the transistor structures are connected to the bit line structures through bit line contact structures. Word line structures are formed, where the word line structures are connected to channel regions of the transistor structures. Capacitor structures are formed, where the capacitor structures are connected to the first source/drain regions of the transistor structures in a one-to-one correspondence.

In some embodiments, for lateral etching on the silicon layers 2022/3022, wet chemical etching is performed by utilizing a silicon etching solution, to remove part of the silicon layers 2022/3022 made of monocrystalline silicon. Specifically, the silicon layers 2022/3022 are selectively etched with an ammonia and deionized water mixture (ADM) or tramethylammonium hydroxide (TMAH) as the silicon etching solution.

In some embodiments, a deposition method for a capacitor structure or a bit line structure may be at least one of the following deposition methods: chemical vapor deposition (CVD), low-pressure chemical vapor deposition (LPCVD), plasma enhanced chemical vapor deposition (PECVD), ultra-high vacuum chemical vapor deposition (UHVCVD), flowable chemical vapor deposition (FCVD), direct liquid injection chemical vapor deposition (DLICVD), rapid thermal chemical vapor deposition (RTCVD), microwave plasma assisted chemical vapor deposition (MPCVD), organometallic chemical vapor deposition (MOCVD), atomic layer deposition (ALD), physical vapor deposition (PVD), and electroplating sputtering.

In the manufacturing method for a semiconductor structure according to the present disclosure, before the initial stacked structure is epitaxially formed on the substrate, a stress adjustment layer is first epitaxially formed, and the germanium content of the first silicon germanium layer in the stress adjustment layer is linearly correlated with a ratio of the thickness of a single layer of the stacked unit in the initial stacked structure formed subsequently to the thickness of the stacked unit. Therefore, subsequently, with the increase of the number of epitaxially grown layers, the warpage problem of the entire wafer is greatly alleviated, and the reliability of the device is improved. In addition, the defects and disadvantages caused by formation of a compensation layer on the backside in the related technologies are avoided, process feasibility is improved, process costs are reduced, and the process difficulty is reduced, thereby greatly improving the process reliability.

Based on the above-mentioned manufacturing method for a semiconductor structure, the present disclosure further provides a semiconductor structure. As shown in FIG. 24 or FIG. 25, the semiconductor structure includes at least a substrate 600/700; a stacked structure 602/702 located on the substrate 600/700, where the stacked structure 602/702 includes multiple stacked units 6020/7020 stacked in a direction perpendicular to a surface of the substrate 600/700, and each of the stacked units 6020/7020 includes at least a stack of one memory cell member and one isolation structure 6023/7023; and a stress adjustment layer 601/701 located between the stacked structure 602/702 and the substrate 600/700. In some embodiments, the memory cell member may be a bit line structure 608 and/or a bit line contact structure 610/710. In some other embodiments, the memory cell member may be a capacitor structure 607/707.

In some embodiments, the stress adjustment layer 601/701 includes a first silicon germanium layer made of germanium-doped silicon, with a germanium content being a first component ratio Y. In some embodiments, the first component ratio Y ranges from 3% to 20%. In some implementations, a bottom layer of the stacked structure 602/702 includes a second silicon germanium layer 6021/7021 with a germanium content being a second component ratio X. In some embodiments, the second component ratio X ranges from 3.2% to 30%. In some embodiments, the germanium content (second component ratio X) in the second silicon germanium layer 6021/7021 is greater than the germanium content (first component ratio Y) in the first silicon germanium layer, and the first component ratio Y is linearly correlated with the second component ratio X. In some embodiments, a stacked unit 6020/7020 of the stacked structure 602/702 includes only a single memory cell member and a single isolation structure 6023/7023. The single isolation structure 6023 has a thickness of A, and the single memory cell member has a thickness of B. A or B ranges from 50 nm to 150 nm. The germanium content (first component ratio Y) in the first silicon germanium layer is linearly correlated with the ratio of the thickness A of the single isolation structure 6023/7023 or the thickness B of the single memory cell member to the thickness of the stacked unit 6020/7020. In some embodiments, the germanium content (first component ratio Y) in the first silicon germanium layer is linearly and positively correlated with the ratio of the thickness A of the single isolation structure 6023/7023 to the thickness of the single stacked unit 6020/7020. In an example embodiment of the present disclosure, the first component ratio Y, the second component ratio X, the thickness A of the single isolation structure 6023/7023, and the thickness B of the single memory cell member satisfy the following relationship: $Y = X ∗ \frac{A}{A + B}$

It should be noted that, the germanium content described herein should be understood as a ratio of the number of germanium atoms in the silicon germanium layer to the total number of all atoms (mainly silicon atoms and germanium atoms) in the silicon germanium layer. The direction of thickness described herein should be understood as a direction perpendicular to the surface of the substrate 600/700. The first silicon germanium layer in the stress adjustment layer, which satisfies the above-mentioned relationship, may be in a partially or completely relaxed state. In some embodiments, after the initial stacked structure is epitaxially grown on the first silicon germanium layer under basically the same process conditions, the warpage (warpage) of the entire wafer changes less than 10 µm, and with the increase of the number of epitaxial layers, a warpage change rate is less than 50%.

In some embodiments, the semiconductor structure according to the present disclosure further includes a protective layer 605/705. A top surface of the protective layer 605/705 is not lower than the top surface of the second silicon germanium layer 6021/7021 located at a bottom layer (namely a single layer closest to the substrate 600/700) in the stacked structure 602/702, and the top surface of the protective layer 605/705 needs to be lower than the top surface of the silicon layer 6022/7022 of the bottom layer in the stacked structure 602/702.

In some embodiments, the semiconductor structure according to the present disclosure further includes capacitor structures 607/707. An extension direction of each of the capacitor structures 607/707 is parallel to a direction of the surface of the substrate 600/700 and an extension direction of the silicon layer 6022/7022. Each of the capacitor structures 607/707 includes a stack of a lower electrode, a dielectric, and an upper electrode. Upper electrodes of multiple capacitor structures 607/707 are connected to an electrode material layer 606/706.

In some embodiments, the semiconductor structure according to the present disclosure further includes transistor structures 6024/7024. In some embodiments, in a cross-sectional direction perpendicular to the silicon layers 6021/7021, multiple transistor structures 6024/7024 are arranged in an array, that is, not only in the direction perpendicular to the substrate 600/700, but also in the same horizontal layer, multiple transistor structures 6024/7024 are arranged at regular intervals. In some embodiments, the transistor structures 6024/7024 may be formed from the silicon layers in the initial stacked structure of the aforementioned embodiments. In some embodiments, the capacitor structures 607/707 are connected to first source/drain regions (not shown) of the transistor structures 6024/7024 in a one-to-one correspondence, and are configured to store or release induced charges. In some embodiments, the capacitor structures 607/707 are connected to the first source/drain regions through capacitor contact structures 604/704.

In an example embodiment of the present disclosure, as shown in FIG. 24, the semiconductor structure according to the present disclosure further includes bit line structures 608 and word line structures 609. An extension direction of each of the bit line structures 608 is parallel to the surface of the substrate 600 and is perpendicular to an extension direction of the silicon layer 6021, and the bit line structures 608 are connected to second source/drain regions (not shown) of the transistor structures 6024, and are configured to provide or sense stored charges in the multiple capacitor structures 607 in a row. An extension direction of each of the word line structures 609 is the same as the direction perpendicular to the surface of the substrate 600, and the word line structures 609 are connected to channel regions (not shown) of the transistor structures 6024, and are configured to control turn-on or turn-off of memory transistors in a column. In some embodiments, the second source/drain regions are connected to the bit line structures 608 through bit line contact structures 610. In some embodiments, each of the memory cell members in the semiconductor structure according to the present disclosure may be a bit line structure 608, a bit line contact structure 610, or a capacitor structure 607.

In an example embodiment of the present disclosure, as shown in FIG. 25, the semiconductor structure according to the present disclosure further includes bit line structures 708 and word line structures 709. An extension direction of each of the bit line structures 708 is the same as a direction perpendicular to the surface of the substrate 700. The bit line structures 708 are connected to second source/drain regions (not shown) of the transistor structures 7024, and are configured to provide or sense stored charges in multiple capacitor structures 707 in a column. An extension direction of each of the word line structures 709 is parallel to the surface of the substrate 700 and perpendicular to an extension direction of the silicon layer 7021. The word line structures 709 are connected to channel regions (not shown) of the transistor structures 7024, and are configured to control turn-on or turn-off of multiple transistor structures 7024 in a row. In some embodiments, the bit line structures 708 are connected to the second source/drain regions through bit line contact structures 710. In some embodiments, each of the memory cell members in the semiconductor structure according to the present disclosure may be a bit line contact structure 710 or a capacitor structure 707.

In some embodiments, the transistor structures 6024/7024 may be made of at least one or any combination of the following materials: silicon, germanium, silicon germanium (SiGe), III-V materials, an indium gallium zinc oxide (IGZO), and a two-dimensional material. In an example embodiment of the present disclosure, the transistor structures 6024/7024 are made of doped monocrystalline silicon.

In some embodiments, the bit line contact structures 610/710 and the capacitor contact structures 604/704 each may be made of any one or more of the following metal silicide materials: cobalt silicide (CoSi), nickel silicide (NiSi), tungsten silicide (WSi), molybdenum silicide (MoSi), titanium silicide (TiSi), tantalum silicide (TaSi), ruthenium silicide (RuSi), and platinum silicide (PtSi).

In some embodiments, the bit line structures 608/708 and the word line structures 609/709 each may be made of any one or a combination of more of the following metals or metal nitride materials: tungsten (W), tungsten nitride (WN), titanium (Ti), titanium nitride (TiN), tantalum (Ta), tantalum nitride (TaN), molybdenum (Mo), molybdenum nitride (MoN), ruthenium (Ru), and ruthenium nitride (RuN).

In some embodiments, the lower electrodes and the upper electrodes of the capacitor structures 607/707 each may be made of at least one or a combination of more of titanium nitride, tantalum nitride, or tungsten nitride, and the dielectric may be made of at least one or a combination of more of silicon oxide (SiO₂), zirconium oxide (ZrO₂), aluminum oxide (Al₂O₃), hafnium oxide (HfO₂), titanium oxide (TiO₂), tantalum oxide (Ta₂O₅), barium strontium titanate (BST), strontium titanate (STO), and lead zironate titanate (PZT).

In some embodiments, the isolation structure 6023/7023 may be made of at least one or any combination of the following materials: silicon oxide, silicon nitride, silicon oxynitride, silicon carbide, silicon carbonitride, and silicon oxycarbonitride. In an example embodiment of the present disclosure, the isolation structure 6023/7023 is made of silicon oxide.

The semiconductor structure according to the present disclosure includes the stress adjustment layer formed between the substrate and the stacked structure, so that the warpage problem of the entire wafer is greatly alleviated, and a related device manufactured from the semiconductor structure has better device reliability and storage performance.

It should be noted that the semiconductor structure according to the embodiment of the present disclosure may be configured to manufacture a 3D DRAM device, or may be configured to manufacture another 3D device in which a sacrificial layer in a stacked structure needs to be laterally etched. There are not too many limitations herein.

Various semiconductor structures shown in this specific implementation may be configured for an electronic device having a storage function. The electronic device may be a terminal device, e.g., a mobile phone, a tablet computer, or a smart bracelet, or may be a personal computer (personal computer, PC), a server, a workstation, or the like. The storage function of the electronic device may be implemented by utilizing the following memories: a dynamic random access memory (DRAM), a ferroelectric random access memory (FRAM), a phase change memory (PCM), a magnetic random access memory (MRAM), or a resistive random access memory (RRAM).

The above-mentioned descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

## Claims

1. A semiconductor structure, comprising:
a substrate (200, 300, 400, 500, 600, 700);
a stacked structure (402, 502, 602, 702) located on the substrate, the stacked structure comprising a plurality of stacked units (4020, 5020, 6020, 7020) stacked in a direction perpendicular to a surface of the substrate, and each of the stacked units comprising at least a stack of one memory cell member (407, 507) and one isolation structure (4023, 5023, 6023, 7023); and
a stress adjustment layer (401, 501, 601, 701) located between the stacked structure and the substrate, the stress adjustment layer comprising a first silicon germanium layer (201, 301), and
the first silicon germanium layer being made of a material comprising germanium-doped silicon, with a germanium content being a first component ratio, the first component ratio being linearly correlated with a ratio of a thickness of the memory cell member or a thickness of the isolation structure to a thickness of the stacked unit, and a direction of thickness being a direction perpendicular to the surface of the substrate.

2. The semiconductor structure according to claim 1, wherein the first component ratio ranges from 3% to 20%.

3. The semiconductor structure according to claim 1, wherein the first silicon germanium layer has a thickness greater than or equal to 3 microns.

4. The semiconductor structure according to claim 1, wherein the stress adjustment layer further comprises a germanium base layer (3010), and the germanium base layer (3010) is located between the substrate and the first silicon germanium layer.

5. The semiconductor structure according to claim 4, wherein the germanium base layer is made of a material comprising silicon-doped germanium, with a germanium content ranging from 50% to 100%.

6. The semiconductor structure according to claim 5, wherein the germanium base layer has a thickness ranging from 5 nanometers to 100 nanometers, and the first silicon germanium layer has a thickness ranging from 100 nanometers to 500 nanometers.

7. The semiconductor structure according to claim 1, wherein the stacked structure further comprises a second silicon germanium layer (4021, 5021, 6021, 7021), and the second silicon germanium layer is located in the stacked unit, which is closest to the substrate, in the stacked structure.

8. The semiconductor structure according to claim 7, wherein the second silicon germanium layer (4021, 5021, 6021, 7021) is made of a material comprising germanium-doped silicon, with a germanium content being a second component ratio, the second component ratio is greater than the first component ratio, and the first component ratio is linearly correlated with the second component ratio.

9. The semiconductor structure according to claim 8, wherein the second component ratio ranges from 3.2% to 30%.

10. The semiconductor structure according to any one of claims 1 to 9, wherein the memory cell members are capacitor structures (607, 707), and the semiconductor structure further comprises:
transistor structures (6024, 7024) located at one end of the stacked structure, first source/drain regions of the transistor structures being connected to the capacitor structures in a one-to-one correspondence;
word line structures (609, 709), the word line structures being connected to channel regions of the transistor structures; and
bit line structures (608, 708), the bit line structures being connected to second source/drain regions of the transistor structures;
or the memory cell members are bit line structures (608, 708), and the semiconductor structure further comprises:
transistor structures (6024, 7024) located at one end of the stacked structure, second source/drain regions of the transistor structures being connected to the bit line structures;
word line structures (609, 709), the word line structures being connected to channel regions of the transistor structures; and
capacitor structures (607, 707), the capacitor structures being connected to first source/drain regions of the transistor structures in a one-to-one correspondence.

11. A manufacturing method for a semiconductor structure, comprising:
providing a substrate (200, 300, 400, 500, 600, 700);
forming a stress adjustment layer (401, 501, 601, 701) on the substrate, the stress adjustment layer comprising a first silicon germanium layer (201, 301);
forming an initial stacked structure (202, 302) on the stress adjustment layer, the initial stacked structure comprising a plurality of initial stacked units (2020, 3020) stacked in a direction perpendicular to a surface of the substrate, and each of the initial stacked units comprising at least a stack of one silicon layer (2022, 3022) and one second silicon germanium layer (2021, 3021); and
replacing the second silicon germanium layers in the initial stacked structure with isolation structures (2023, 3023, 4023, 5023), and replacing part of the silicon layers with memory cell members (407, 507) to form a stacked structure (402, 502, 602, 702), the stacked structure comprising a plurality of stacked units (4020, 5020, 6020, 7020) stacked in a direction perpendicular to the surface of the substrate, each of the stacked units comprising at least a stack of one of the memory cell members and one of the isolation structures, and
the first silicon germanium layer being made of a material comprising germanium-doped silicon, with a germanium content being a first component ratio, the first component ratio being linearly correlated with a ratio of a thickness of the memory cell member or a thickness of the isolation structure to a thickness of the stacked unit, and a direction of thickness being a direction perpendicular to the surface of the substrate.

12. The manufacturing method for a semiconductor structure according to claim 11, wherein the forming a stress adjustment layer (401, 501, 601, 701) on the substrate, the stress adjustment layer comprising a first silicon germanium layer (201, 301) comprises:
growing the first silicon germanium layer on the surface of the substrate by utilizing an epitaxial growth method,
wherein the first silicon germanium layer has a thickness greater than 3 microns, and the first component ratio ranges from 3% to 20%.

13. The manufacturing method for a semiconductor structure according to claim 11, wherein the forming a stress adjustment layer (401, 501, 601, 701) on the substrate, the stress adjustment layer comprising a first silicon germanium layer (201, 301) and a germanium base layer (3010) comprises:
growing the germanium base layer on the surface of the substrate by utilizing an epitaxial growth method, and growing the first silicon germanium layer on a surface of the germanium base layer by utilizing the epitaxial growth method,
wherein the germanium base layer is made of a material comprising silicon-doped germanium, with a germanium content ranging from 50% to 100%, the germanium base layer has a thickness ranging from 5 nanometers to 100 nanometers, and the first silicon germanium layer has a thickness ranging from 100 nanometers to 500 nanometers.

14. The manufacturing method for a semiconductor structure according to claim 11, wherein the forming an initial stacked structure (202, 302) on the stress adjustment layer comprises:
growing the plurality of silicon layers and the plurality of second silicon germanium layers alternately on a surface of the first silicon germanium layer by utilizing an epitaxial growth method, to form the plurality of initial stacked units stacked in the direction perpendicular to the surface of the substrate, each of the initial stacked units comprising at least a stack of one of the silicon layers and one of the second silicon germanium layers,
wherein the second silicon germanium layer is made of a material comprising germanium-doped silicon, with a germanium content being a second component ratio, the second component ratio is greater than the first component ratio, the first component ratio is linearly correlated with the second component ratio, and the second component ratio ranges from 3.2% to 30%.

15. The manufacturing method for a semiconductor structure according to any one of claims 11 to 14, wherein the memory cell members are capacitor structures (607, 707), and the manufacturing method for a semiconductor structure further comprises:
forming transistor structures (6024, 7024) located at one end of the initial stacked structure or the stacked structure, first source/drain regions of the transistor structures being connected to the capacitor structures in a one-to-one correspondence;
forming word line structures (609, 709), the word line structures being connected to channel regions of the transistor structures; and
forming bit line structures (608, 708), the bit line structures being connected to second source/drain regions of the transistor structures;
or the memory cell members are bit line structures (608, 708), and the manufacturing method for a semiconductor structure further comprises:
forming transistor structures (6024, 7024) located at one end of the stacked structure, second source/drain regions of the transistor structures being connected to the bit line structures;
forming word line structures (609, 709), the word line structures being connected to channel regions of the transistor structures; and
forming capacitor structures (607, 707), the capacitor structures being connected to first source/drain regions of the transistor structures in a one-to-one correspondence.
